# FASCICULE DE BREVET EUROPEEN

(11) **EP 3 289 616 B1**
(45) Date de publication et mention de la délivrance du brevet: **02.03.2022**
(21) Numéro de dépôt: 16726125.4
(22) Date de dépôt: 27.04.2016
(51) Int. Cl.: H01L 31/0288, H01L 31/18, H01L 31/068, H01L 21/225

(54) **CELLULE PHOTOVOLTAÏQUE ET SON PROCÉDÉ DE FABRICATION**
PHOTOVOLTAISCHE ZELLE UND VERFAHREN ZU IHRER HERSTELLUNG
PHOTOVOLTAIC CELL AND ITS FABRICATION METHOD

(30) Priorité: 28.04.2015 FR 1553834
(43) Date de publication de la demande: 07.03.2018
(73) Titulaire: Commissariat à l'Énergie Atomique et aux Énergies Alternatives, 75015 Paris (FR)
(72) Inventeur: BLEVIN, Thomas, 73000 Chambéry (FR); CABAL, Raphaël, 73000 Chambéry (FR); GRANGE, Bernadette, 73000 Chambéry (FR)
(74) Mandataire: INNOV-GROUP
(86) Numéro de dépôt international: PCT/FR2016/050989
(87) Numéro de publication internationale: WO 2016/174351

(56) Documents cités:
- DE-A1-102013 211 746
- US-A- 2 794 846
- US-A- 4 152 824
- US-A1- 2011 177 652
- US-B1- 6 998 288

## Description

### Domaine technique

La présente invention a trait à un procédé de fabrication d'une cellule photovoltaïque, ainsi qu'à une cellule photovoltaïque.

### Etat de l'art

Un procédé connu de l'état de la technique, notamment du document « Codiffused bifacial n-type Solar Cells (CoBiN) », P. Rothhardt et al., Energy Procedia, vol. 55, 2014, 287-294, comporte les étapes :
a0) prévoir un substrat semi-conducteur réalisé dans un matériau à base de silicium cristallin dopé de type n, le substrat comportant une première surface et une seconde surface opposée,
b0) former une première couche diélectrique à la première surface du substrat, la première couche diélectrique comportant des atomes de bore, le substrat et la première couche diélectrique formant une structure,
c0) appliquer un recuit thermique à la structure sous une atmosphère contenant du POCl₃ adapté pour :
   - diffuser les atomes de bore de la première couche diélectrique jusqu'à la première surface du substrat de manière à former une première zone semi-conductrice, la première zone semi-conductrice formée par les atomes de bore diffusés étant destinée à être en contact avec une électrode,
   - diffuser les atomes de phosphore issus du POCl₃ jusqu'à la seconde surface du substrat de manière à former une deuxième zone semi-conductrice, la deuxième zone semi-conductrice formée par les atomes de phosphore diffusés étant destinée à être en contact avec une électrode.

La première couche diélectrique formée lors de l'étape b) comporte une première sous-couche réalisée dans un matériau à base d'un oxyde de silicium SiOₓ et une deuxième sous-couche réalisée dans un matériau à base d'un verre borosilicate (BSG). La première couche diélectrique est formée par un dépôt chimique en phase vapeur à pression atmosphérique.

L'exécution de l'étape c0) s'accompagne de la formation d'une couche d'un verre phosphosilicate (PSG) à la seconde surface du substrat.

Puis le BSG et le PSG sont retirés par gravure après l'étape c0) avec une solution à base d'acide fluorhydrique. Ainsi, après la gravure du BSG et du PSG et le nettoyage des première et seconde surfaces du substrat, une première et une deuxième couches de passivation sont formées respectivement à la première et à la seconde surfaces du substrat. La première couche de passivation comporte une première sous-couche d'alumine et une deuxième sous-couche de nitrure de silicium SiNₓ. La deuxième couche de passivation comporte une première sous-couche d'oxynitrure de silicium SiOₓN_{y} et une deuxième sous-couche de nitrure de silicium SiNₓ.

Un tel procédé de l'état de la technique n'est pas entièrement satisfaisant dans la mesure où il comporte un nombre important d'étapes à exécuter. En particulier, la formation puis la suppression du BSG et du PSG introduisent une complexité et un temps d'opération non négligeable dans la mise en œuvre de ce procédé.

Le document US 4 152 824 A divulgue un procédé de fabrication de cellules photovoltaïques, comportant la formation d'une couche de SiO₂ dopée bore et la formation d'une couche de SiO₂ dopée phosphore utilisant des diffusions simultanées.

Le document US 6 998 288 B1 divulgue un procédé de fabrication de cellules photovoltaïques, comportant la formation d'une couche de SiO₂ dopée bore et la formation d'une couche de SiO₂ dopée phosphore utilisant deux recuits thermiques successifs.

Le document DE 10 2013 211746 A1 divulgue un procédé de fabrication de cellules photovoltaïques, comportant la formation d'une couche d'oxyde de silicium dopée bore et la formation de nitrure de silicium dopée phosphore ou d'une couche d'oxyde de silicium dopée phosphore utilisant des diffusions simultanées par recuit dans une atmosphère d'oxygène ou d'azote.

### Exposé de l'invention

Ainsi, la présente invention vise à remédier en tout ou partie aux inconvénients précités, et concerne à cet effet un procédé de fabrication d'une cellule photovoltaïque, défini selon la revendication 1 annexée, comportant les étapes:
a) prévoir une structure comportant:
   - un substrat en un matériau semi-conducteur à base de silicium cristallin, et comportant une première surface et une seconde surface opposée;
   - une première couche diélectrique formée à la première surface du substrat, et comportant des atomes de bore, la première couche diélectrique étant à base d'un oxynitrure de silicium SiOₓN_{y} vérifiant 0 < y < x et x < 0,50, de préférence hydrogéné;
   - une deuxième couche diélectrique formée à la seconde surface du substrat, et comportant des atomes de phosphore ou d'arsenic;
d) appliquer un recuit thermique à la structure sous une atmosphère oxydante, ledit recuit thermique étant adapté pour:
   - former une première zone semi-conductrice destinée à être en contact avec une électrode (E), la première zone semi-conductrice étant formée par une diffusion des atomes de bore dans le substrat depuis la première couche diélectrique jusqu'à la première surface du substrat, la première zone semi-conductrice et la première couche diélectrique présentant une interface;
   - former une deuxième zone semi-conductrice destinée à être en contact avec une électrode (E), la deuxième zone semi-conductrice étant formée par une diffusion des atomes de phosphore ou d'arsenic dans le substrat depuis la deuxième couche diélectrique jusqu'à la seconde surface du substrat;
   - enrichir la première couche diélectrique en oxygène de sorte que l'oxynitrure de silicium SiOₓN_{y} vérifie 0,50 ≤ x ≤ 0,66, après l'étape d), de manière à passiver l'interface;
   - l'étape d) se déroulant de manière continue de sorte que la formation des première et deuxième zones semi-conductrices sont concomitantes;
f) former une électrode en contact avec la première zone semi-conductrice à travers la première couche diélectrique et une électrode en contact avec la deuxième zone semi-conductrice à travers la deuxième couche diélectrique.

Par « cristallin », on entend la forme multicristalline ou la forme monocristalline du silicium, excluant donc le silicium amorphe.

Ainsi, un tel procédé selon l'invention permet de réduire le nombre d'étapes à exécuter grâce à :
- une co-diffusion des atomes de bore et de phosphore ou d'arsenic lors de l'étape d),
- une atmosphère oxydante qui permet d'obtenir des propriétés de passivation satisfaisantes pour la structure.

L'oxynitrure de silicium est de préférence hydrogéné afin d'améliorer la qualité de la passivation.

Il n'est donc pas nécessaire de graver la première couche diélectrique après l'étape d), puis de déposer une couche de passivation dédiée, contrairement au procédé de l'état de la technique. Autrement dit, la première couche diélectrique est conservée dans le procédé selon l'invention.

Par ailleurs, l'étape d) se déroule de manière continue ; la formation des première et deuxième zones semi-conductrices sont concomitantes.

Selon une forme d'exécution, l'atmosphère oxydante présente une pression partielle en oxygène adaptée de sorte que l'oxynitrure de silicium SiOₓN_{y} de la première couche diélectrique vérifie 0,50 ≤ *x* ≤ 0,66, après l'étape d).

Ainsi, le demandeur a constaté une amélioration importante des propriétés de passivation de la structure, en particulier à l'interface entre la première zone semi-conductrice et la première couche diélectrique.

De manière quantitative, des mesures de la densité de courant de saturation de l'émetteur, notée J₀ₑ, effectuées sur une structure comportant un substrat en silicium dopé de type n, dont chaque face comporte une telle première couche diélectrique, donnent une valeur de J₀ₑ de l'ordre de 120 fA/cm². En l'absence d'atmosphère oxydante pour le recuit thermique, les mêmes mesures donnent une valeur de J₀ₑ supérieure à 1000 fA/cm² (de l'ordre de 1400 fA/cm²).

Selon un mode de mise en œuvre, les atomes de bore présentent une proportion atomique dans la première couche diélectrique comprise entre 10% et 50%, de préférence comprise entre 10% et 30%, avant l'étape d).

Selon un mode de mise en œuvre, les atomes de bore présentent une proportion atomique dans la première couche diélectrique comprise entre 1% et 10%, de préférence comprise entre 3% et 8%, après l'étape d).

Ainsi, de telles proportions atomiques de bore permettent à la fois de :
- former une première zone semi-conductrice et par là-même une zone de contact électrique de bonne qualité, c'est-à-dire avec une concentration atomique surfacique supérieure à 10¹⁹ at./cm³, de préférence comprise entre 10¹⁹ at./cm³ et 3×10²⁰ at./cm³,
- conserver une bonne qualité de passivation de la première couche diélectrique obtenue par l'enrichissement en oxygène lors de l'étape d), une proportion atomique trop élevée de bore affectant les propriétés de passivation.

Selon l'invention, l'oxynitrure de silicium SiOₓN_{y} vérifie x < 0,50 avant l'étape d).

Selon un mode de mise en œuvre, l'oxynitrure de silicium SiOₓN_{y} vérifie 0 < *y* ≤ 0,10, de préférence 0 < *y* ≤ 0,05, avant l'étape d), et de préférence après l'étape d).

Selon un mode de mise en œuvre, l'atmosphère oxydante comporte un mélange de dioxygène et d'un gaz neutre choisi parmi l'argon, l'azote, ou un mélange d'argon et d'azote.

Ainsi, une telle atmosphère oxydante permet d'introduire des atomes d'oxygène dans la première couche diélectrique de sorte que l'oxynitrure de silicium SiOₓN_{y} vérifie 0,50 ≤ *x* ≤ 0,66, après l'étape d).

Avantageusement, l'étape d) comporte :
- une première étape lors de laquelle l'atmosphère sous laquelle est appliqué le recuit thermique comporte uniquement le gaz neutre,
- une deuxième étape lors de laquelle le dioxygène est introduit dans l'atmosphère.

Selon une forme d'exécution, le recuit thermique appliqué lors de l'étape d) présente :
- une valeur de température de recuit comprise entre 850°C et 950°C, de préférence comprise entre 900°C et 950°C,
- une valeur de durée de recuit comprise entre 10 minutes et 1 heure, de préférence comprise entre 30 minutes et 1 heure.

Ainsi, un tel budget thermique permet à la fois :
- de diffuser les atomes de bore à la première surface du substrat,
- de diffuser les atomes de phosphore ou d'arsenic à la seconde surface du substrat.

Par « budget thermique », on entend le choix d'une valeur de température de recuit et le choix d'une valeur de durée de recuit.

Selon une forme d'exécution, les atomes de phosphore ou d'arsenic présentent une proportion atomique dans la deuxième couche diélectrique comprise entre 1% et 10% avant l'étape d).

Selon une forme d'exécution, les atomes de phosphore ou d'arsenic présentent une proportion atomique dans la deuxième couche diélectrique comprise entre 1% et 10%, de préférence comprise entre 1% et 5%, après l'étape d).

Bien entendu, la proportion atomique des atomes de phosphore ou d'arsenic dans la deuxième couche diélectrique après l'étape d) est inférieure à la proportion atomique avant l'étape d).

Ainsi, de telles proportions atomiques de phosphore ou d'arsenic permet à la fois de :
- former une deuxième zone semi-conductrice et par là-même une zone de contact de bonne qualité, c'est-à-dire avec une concentration atomique surfacique supérieure à 10²⁰ at./cm³, de préférence comprise entre 10²⁰ at./cm³ et 10²¹ at./cm³,
- conserver une bonne qualité de passivation de la deuxième couche diélectrique, une proportion atomique trop élevée de phosphore ou d'arsenic affectant les propriétés de passivation.

Selon une forme d'exécution, la deuxième couche diélectrique est à base d'un oxynitrure de silicium SiOₓN_{y} vérifiant 0 ≤ *x* < *y*, de préférence hydrogéné.

Ainsi, ce matériau permet de passiver la seconde surface du substrat. L'oxynitrure de silicium est de préférence hydrogéné afin d'améliorer la qualité de la passivation. Lorsque x=0, l'oxynitrure de silicium est un nitrure de silicium.

Selon une forme d'exécution, l'oxynitrure de silicium SiOₓN_{y} de la deuxième couche diélectrique vérifie 0 ≤ *x* ≤ 0,05 avant et après l'étape d).

Selon une forme d'exécution, l'oxynitrure de silicium SiOₓN_{y} de la deuxième couche diélectrique vérifie 0,30 ≤ *y* ≤ 0,55 avant et après l'étape d).

Selon une forme d'exécution, le procédé comporte les étapes :
e1) former une première couche diélectrique additionnelle sur la première couche diélectrique, l'étape e1) étant exécutée après l'étape d),
e2) former une deuxième couche diélectrique additionnelle sur la deuxième couche diélectrique,
les première et deuxième couches diélectriques additionnelles étant chacune à base d'un oxynitrure de silicium SiOₓN_{y} vérifiant 0 ≤ *x* < *y*, de préférence hydrogéné.

Ainsi, de telles couches diélectriques additionnelles permettent à la fois d'améliorer la passivation de la première et de la seconde surfaces du substrat, et de former une couche optique dite antireflet de par une épaisseur adaptée. La couche optique antireflet permet de réduire les pertes optiques liées aux réflexions du rayonnement lumineux, et donc d'optimiser l'absorption du rayonnement lumineux par le substrat. Lorsque x=0, l'oxynitrure de silicium est un nitrure de silicium.

En outre, l'étape e1) est exécutée après l'étape d) de sorte que la première couche diélectrique peut être aisément enrichie d'oxygène lors de l'étape d) par l'atmosphère oxydante.

Selon un mode de mise en œuvre, le procédé comporte une étape consistant à former une couche à base de SiON, dépourvue d'atomes de bore, sur la première couche, ladite étape étant exécutée avant l'étape d).

Ainsi, un avantage procuré par la couche à base de SiON est la possibilité de réduire l'épaisseur de la première couche diélectrique afin d'être moins absorbante et d'obtenir un gain en courant débité par la cellule photovoltaïque. En effet, la couche à base de SiON permet de minimiser la croissance ou l'oxydation de la couche sous-jacente, c'est-à-dire la première couche diélectrique, lors de l'étape d).

Selon différents modes de mise en œuvre, le substrat prévu lors de l'étape a) est dopé de type n ou p, et la première surface ou la seconde surface du substrat est destinée à être exposée à un rayonnement lumineux.

Ainsi, selon un premier mode de mise en œuvre, le substrat prévu lors de l'étape a) est dopé de type n et la première surface du substrat est destinée à être exposée à un rayonnement lumineux de manière à former une architecture à émetteur standard.

Selon un deuxième mode de mise en œuvre, le substrat prévu lors de l'étape a) est dopé de type n et la seconde surface du substrat est destinée à être exposée à un rayonnement lumineux de manière à former une architecture à émetteur inversé.

Selon un troisième mode de mise en œuvre, le substrat prévu lors de l'étape a) est dopé de type p et la première surface du substrat est destinée à être exposée à un rayonnement lumineux de manière à former une architecture à émetteur inversé.

Selon un quatrième mode de mise en œuvre, le substrat prévu lors de l'étape a) est dopé de type p et la seconde surface du substrat est destinée à être exposée à un rayonnement lumineux de manière à former une architecture à émetteur standard.

La présente invention concerne également une cellule photovoltaïque, définie selon la revendication 13 annexée.

Ainsi, une telle cellule photovoltaïque selon l'invention se distingue de l'état de la technique par la présence :
- d'une première couche diélectrique formée à la première surface du substrat, réalisée dans un matériau à base d'oxynitrure de silicium, la première couche diélectrique comportant des atomes de bore qui n'ont pas diffusé jusqu'à la première surface du substrat, l'oxynitrure de silicium étant en outre enrichi en oxygène, ce qui lui confère de bonnes propriétés de passivation,
- d'une deuxième couche diélectrique formée à la seconde surface du substrat, la deuxième couche diélectrique comportant des atomes de phosphore ou d'arsenic qui n'ont pas diffusé jusqu'à la seconde surface du substrat.

La quantité d'atomes de bore et de phosphore ou d'arsenic qui n'ont pas diffusé demeure suffisante pour détecter leur présence au sein de la couche diélectrique correspondante, si bien qu'une telle cellule photovoltaïque peut être détectée aisément par ingénierie inverse.

Avantageusement, l'oxynitrure de silicium SiOₓN_{y} vérifie 0 < y ≤ 0,10, de préférence 0 < *y* ≤ 0,05.

Selon l'invention, les atomes de bore présentent une proportion atomique dans le matériau diélectrique de la première couche comprise entre 1% et 10%, de préférence comprise entre 3% et 8%.

Avantageusement, le matériau diélectrique de la deuxième couche est à base d'un oxynitrure de silicium SiOₓN_{y} vérifiant 0 ≤ *x* < *y*, et comporte de préférence de l'hydrogène.

Avantageusement, l'oxynitrure de silicium SiOₓN_{y} de la deuxième couche vérifie 0 ≤ *x* ≤ 0,05.

Avantageusement, l'oxynitrure de silicium SiOₓN_{y} de la deuxième couche vérifie 0,30 ≤ *y* ≤ 0,55.

Selon l'invention, les atomes de phosphore ou d'arsenic présentent une proportion atomique dans le matériau diélectrique de la deuxième couche comprise entre 1% et 10%, de préférence comprise entre 1% et 5%.

Avantageusement, la cellule photovoltaïque comporte des première et deuxième couches diélectriques additionnelles formées respectivement sur les première et deuxième couches diélectriques, et les première et deuxième couches diélectriques additionnelles sont, de préférence, chacune à base d'un oxynitrure de silicium SiOₓN_{y} vérifiant 0 ≤ *x* < y, de préférence hydrogéné.

Avantageusement, la première couche présente une épaisseur comprise entre 3 nm et 100 nm, de préférence comprise entre 20 nm et 35 nm.

Selon différents modes de réalisation, le substrat est dopé de type n ou p, et la première surface ou la seconde surface du substrat est destinée à être exposée à un rayonnement lumineux.

Ainsi, selon un premier mode de réalisation, le substrat est dopé de type n et la première surface du substrat est destinée à être exposée à un rayonnement lumineux de manière à former une architecture à émetteur standard.

Selon un deuxième mode de réalisation, le substrat prévu est dopé de type n et la seconde surface du substrat est destinée à être exposée à un rayonnement lumineux de manière à former une architecture à émetteur inversé.

Selon un troisième mode de réalisation, le substrat est dopé de type p et la première surface du substrat est destinée à être exposée à un rayonnement lumineux de manière à former une architecture à émetteur inversé.

Selon un quatrième mode de réalisation, le substrat est dopé de type p et la seconde surface du substrat est destinée à être exposée à un rayonnement lumineux de manière à former une architecture à émetteur standard.

Selon un mode de réalisation, la cellule photovoltaïque comporte une couche à base de B₂O₃ formée entre la première surface du substrat et la première couche.

### Brève description des dessins

D'autres caractéristiques et avantages apparaîtront dans la description qui va suivre de différents modes de mise en œuvre d'un procédé selon l'invention, donnés à titre d'exemples non limitatifs, en référence aux dessins annexés dans lesquels :
- les figures 1a à 1g sont des vues schématiques en coupe illustrant différentes étapes d'un procédé selon l'invention,
- les figures 2 à 5 sont des vues schématiques en coupe de cellules photovoltaïques obtenues à partir d'un procédé selon l'invention, les flèches indiquant la face de la cellule destinée à être exposée à un rayonnement lumineux.

### Exposé détaillé des modes de réalisation

Pour les différents modes de mise en œuvre, les mêmes références seront utilisées pour des éléments identiques ou assurant la même fonction, par souci de simplification de la description. Les caractéristiques techniques décrites ci-après pour différents modes de mise en œuvre sont à considérer isolément ou selon toute combinaison techniquement possible.

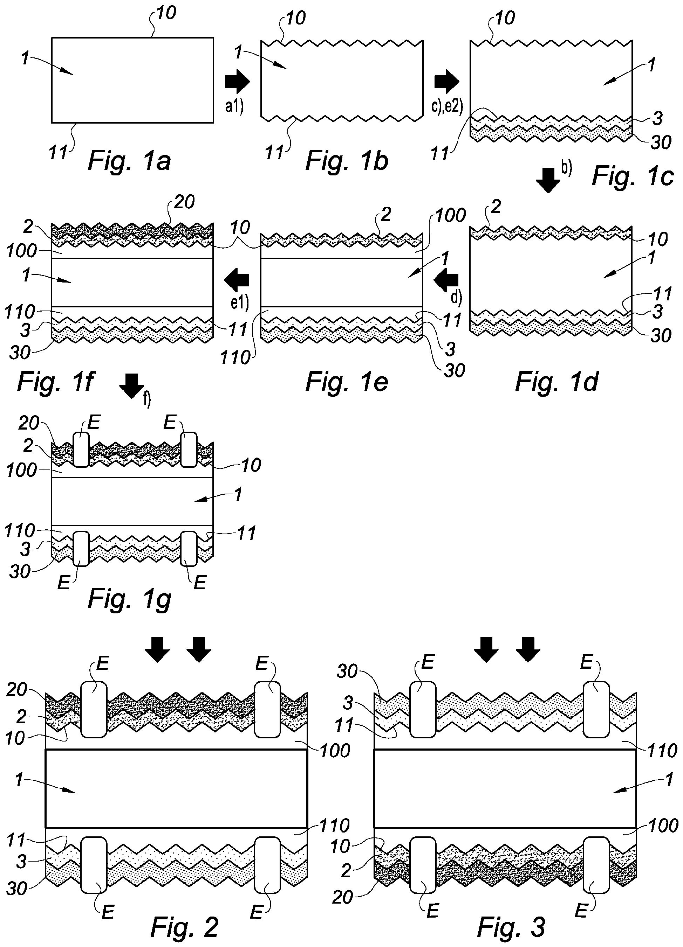

Le procédé illustré aux figures 1a à 1g est un procédé de fabrication d'une cellule photovoltaïque, comportant les étapes :
a) prévoir une structure 1, 2, 3 comportant :
   - un substrat 1 en un matériau semi-conducteur à base de silicium cristallin, et comportant une première surface 10 et une seconde surface 11 opposée ;
   - une première couche diélectrique 2 formée à la première surface 10 du substrat 1, et comportant des atomes de bore, la première couche diélectrique 2 étant à base d'un oxynitrure de silicium SiOₓN_{y} vérifiant 0 < *y* < *x,* de préférence hydrogéné ;
   - une deuxième couche diélectrique 3 formée à la seconde surface 11 du substrat 1, et comportant des atomes de phosphore ou d'arsenic ;
d) appliquer un recuit thermique à la structure 1, 2, 3 sous une atmosphère oxydante, ledit recuit thermique étant adapté pour :
   - former une première zone semi-conductrice 100 destinée à être en contact avec une électrode E, la première zone semi-conductrice 100 étant formée par une diffusion des atomes de bore dans le substrat 1 depuis la première couche diélectrique 2 jusqu'à la première surface 10 du substrat 1, la première zone semi-conductrice 100 et la première couche diélectrique 2 présentant une interface ;
   - former une deuxième zone semi-conductrice 110 destinée à être en contact avec une électrode E, la deuxième zone semi-conductrice 110 étant formée par une diffusion des atomes de phosphore ou d'arsenic dans le substrat 1 depuis la deuxième couche diélectrique 3 jusqu'à la seconde surface 11 du substrat 1 ;
   - enrichir la première couche diélectrique 2 en oxygène de sorte que l'oxynitrure de silicium SiOₓN_{y} vérifie 0,50 ≤ *x* ≤ 0,66, après l'étape d), de manière à passiver l'interface, l'étape d) étant illustrée à la figure 1e.

L'étape a) comporte avantageusement les étapes :
b) former la première couche diélectrique 2 à la première surface 10 du substrat 1, l'étape b) étant illustrée à la figure 1d,
c) former la deuxième couche diélectrique 3 à la seconde surface 11 du substrat 1, l'étape c) étant illustrée à la figure 1c.

Dans le mode de mise en œuvre illustré aux figures 1a à 1g, l'étape c) est exécutée avant l'étape b). Toutefois, les étapes b) et c) peuvent être interverties. Autrement dit, l'étape b) peut être exécutée avant l'étape c). En revanche, l'étape d) est exécutée après les étapes b) et c).

L'étape a) comporte avantageusement une étape a1) former des motifs de texturation sur les première et seconde surfaces 10, 11 du substrat 1, l'étape a1) étant illustrée à la figure 1b). Une telle texturation des première et seconde surfaces 10, 11 du substrat 1 permet une réduction importante du coefficient de réflexion et des pertes optiques dans la cellule photovoltaïque.

La première couche diélectrique 2 formée lors de l'étape b) présente avantageusement une épaisseur comprise entre 3 nm et 100 nm, préférentiellement comprise entre 20 nm et 35 nm. Les atomes de bore présentent avantageusement une proportion atomique dans la première couche diélectrique 2 comprise entre 10% et 50%, de préférence comprise entre 10% et 30%, avant l'étape d). Les atomes de bore présentent avantageusement une proportion atomique dans la première couche diélectrique 2 comprise entre 1% et 10%, de préférence comprise entre 3% et 8%, après l'étape d). L'oxynitrure de silicium SiOₓN_{y} vérifie *x* < 0,50 avant l'étape d). L'oxynitrure de silicium SiOₓN_{y} vérifie avantageusement 0 < *y* ≤ 0,10, de préférence 0 < *y* ≤ 0,05, avant l'étape d), et de préférence après l'étape d). Lorsque la première couche diélectrique 2 est réalisée dans un matériau à base d'un oxynitrure de silicium hydrogéné, l'étape b) est avantageusement exécutée par un dépôt chimique en phase vapeur (PECVD pour *Plasma-Enhanced Chemical Vapor Deposition* en langue anglaise) à partir de gaz réactifs comportant du silane SiH₄ et du protoxyde d'azote N₂O. Les atomes de bore sont avantageusement incorporés à l'oxynitrure de silicium hydrogéné par une injection de diborane B₂H₆ avec les gaz réactifs. Le procédé comporte avantageusement une étape consistant à former une couche à base de SiON, dépourvue d'atomes de bore, sur la première couche diélectrique 2. Cette étape de formation de la couche à base de SiON est exécutée avant l'étape d).

La deuxième couche diélectrique 3 formée lors de l'étape c) présente avantageusement une épaisseur comprise entre 10 nm et 50 nm, préférentiellement comprise entre 10 nm et 30 nm. Les atomes de phosphore ou d'arsenic présentent une proportion atomique dans la deuxième couche diélectrique 3 comprise entre 1% et 10% avant l'étape d). Les atomes de phosphore ou d'arsenic présentent avantageusement une proportion atomique dans la deuxième couche diélectrique 3 comprise entre 1% et 10%, de préférence comprise entre 1% et 5%, après l'étape d). La deuxième couche diélectrique 3 formée lors de l'étape c) est avantageusement à base d'un oxynitrure de silicium SiOₓN_{y} vérifiant 0 ≤ *x* < *y*, de préférence hydrogéné. L'oxynitrure de silicium SiOₓN_{y} de la deuxième couche diélectrique 3 vérifie avantageusement 0 ≤ *x* ≤ 0,05 avant et après l'étape d). L'oxynitrure de silicium SiOₓN_{y} de la deuxième couche diélectrique 3 vérifie avantageusement 0,30 ≤ *y* ≤ 0,55 avant et après l'étape d).

Lorsque la deuxième couche diélectrique 3 est réalisée dans un matériau à base d'un oxynitrure de silicium hydrogéné, l'étape c) est avantageusement exécutée par un dépôt chimique en phase vapeur (PECVD pour *Plasma-Enhanced Chemical Vapor Deposition* en langue anglaise) à partir de gaz réactifs comportant du silane SiH₄ et du NH₃. Lorsque la deuxième couche diélectrique 3 comporte des atomes de phosphore, lesdits atomes sont avantageusement incorporés à l'oxynitrure de silicium hydrogéné par une injection de phosphine PH₃ avec les gaz réactifs. Lorsque la deuxième couche diélectrique 3 comporte des atomes d'arsenic, lesdits atomes sont avantageusement incorporés à l'oxynitrure de silicium hydrogéné par une injection d'arsine AsH₃ avec les gaz réactifs.

Le recuit thermique est appliqué lors de l'étape d) sous une atmosphère oxydante adaptée pour enrichir en oxygène la première couche diélectrique. Le recuit thermique appliqué lors de l'étape d) est un recuit thermique global au sens où il est appliqué à l'ensemble de la structure 1, 2, 3. Il ne s'agit donc pas d'un recuit thermique localisé appliqué sur une partie de la structure 1, 2, 3, par exemple à l'aide d'un laser. En particulier, le recuit thermique est appliqué lors de l'étape d) sur la totalité de la première couche diélectrique 2 formée lors de l'étape b). En d'autres termes, aucun retrait d'une partie de la première couche diélectrique 2 n'est effectué avant l'étape d). L'étape d) est avantageusement exécutée dans un four.

Le recuit thermique appliqué lors de l'étape d) présente avantageusement :
- une valeur de température de recuit comprise entre 850°C et 950°C, de préférence comprise entre 900°C et 950°C,
- une valeur de durée de recuit comprise entre 10 minutes et 1 heure, de préférence comprise entre 30 minutes et 1 heure.

Le recuit thermique est avantageusement appliqué lors de l'étape d) sous une pression atmosphérique.

L'atmosphère oxydante comporte avantageusement un mélange de dioxygène et d'un gaz neutre choisi parmi l'argon, l'azote, ou un mélange d'argon et d'azote. L'atmosphère oxydante est avantageusement constituée par un mélange de dioxygène et d'un gaz neutre choisi parmi l'argon, l'azote, ou un mélange d'argon et d'azote. L'atmosphère oxydante est avantageusement dépourvue d'agent dopant telle que la phosphine.

Après l'étape d), une couche à base de B₂O₃ peut être formée entre la première surface 10 du substrat 1 et la première couche diélectrique 2.

Le procédé comporte avantageusement les étapes :
e1) former une première couche diélectrique additionnelle 20 sur la première couche diélectrique 2,
e2) former une deuxième couche diélectrique additionnelle 30 sur la deuxième couche diélectrique 3.

L'étape e1) est exécutée après l'étape d) de sorte que l'oxynitrure de silicium de la première couche diélectrique 2 peut être aisément enrichi d'oxygène lors de l'étape d) par l'atmosphère oxydante.

Comme illustré à la figure 1c, l'étape e2) et l'étape c) sont avantageusement exécutées simultanément, les première et deuxième couches diélectriques 2, 3, la deuxième couche diélectrique additionnelle 30 et le substrat 1 formant la structure à laquelle est appliqué le recuit thermique lors de l'étape d). Ainsi, le nombre d'étapes du procédé est réduit.

Les première et deuxième couches diélectriques additionnelles 20, 30 sont avantageusement chacune à base d'un oxynitrure de silicium SiOₓN_{y} vérifiant 0 ≤ *x < y,* de préférence hydrogéné.

Comme illustré à la figure 1g, le procédé comporte une étape f) mettre en contact chacune des première et deuxième zones semi-conductrices 100, 110 avec une électrode E. L'étape f) comporte avantageusement une étape de métallisation, de préférence exécutée par sérigraphie. Chaque électrode E est avantageusement réalisée en argent et/ou en aluminium.

Selon un premier mode de mise en œuvre illustré à la figure 2, le substrat 1 prévu lors de l'étape a) est dopé de type n et la première surface 10 du substrat 1 est destinée à être exposée à un rayonnement lumineux (symbolisé par une double flèche à la figure 2) de manière à former une architecture de type n à émetteur standard. La première zone semi-conductrice 100 forme l'émetteur tandis que la deuxième zone semi-conductrice 110, du même type de dopage que le substrat 1, est de type BSF (acronyme pour « *Back Surface Field* » en langue anglaise).

Selon un deuxième mode de mise en œuvre illustré à la figure 3, le substrat 1 prévu lors de l'étape a) est dopé de type n et la seconde surface 11 du substrat 1 est destinée à être exposée à un rayonnement lumineux (symbolisé par une double flèche à la figure 3) de manière à former une architecture de type n à émetteur inversé. La première zone semi-conductrice 100 forme l'émetteur. La deuxième zone semi-conductrice 110, du même type de dopage que le substrat 1, est de type FSF (acronyme pour « *Front Surface Field* » en langue anglaise).

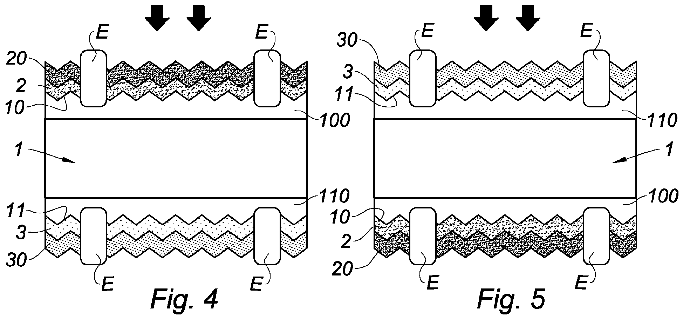

Selon un troisième mode de mise en œuvre illustré à la figure 4, le substrat 1 prévu lors de l'étape a) est dopé de type p et la première surface 10 du substrat 1 est destinée à être exposée à un rayonnement lumineux (symbolisé par une double flèche à la figure 2) de manière à former une architecture de type p à émetteur inversé. La deuxième zone semi-conductrice 110 forme l'émetteur. La première zone semi-conductrice 100, du même type de dopage que le substrat 1, est de type FSF (acronyme pour « *Front Surface Field* » en langue anglaise). L'étape b) est avantageusement exécutée avant l'étape c).

Selon un quatrième mode de mise en œuvre illustré à la figure 5, le substrat 1 prévu lors de l'étape a) est dopé de type p et la seconde surface 11 du substrat 1 est destinée à être exposée à un rayonnement lumineux (symbolisé par une double flèche à la figure 3) de manière à former une architecture de type p à émetteur standard. La deuxième zone semi-conductrice 110 forme l'émetteur tandis que la première zone semi-conductrice 100, du même type de dopage que le substrat 1, est de type BSF (acronyme pour « *Back Surface Field* » en langue anglaise). L'étape b) est avantageusement exécutée avant l'étape c).

### Exemple de réalisation :

Le substrat 1 est à base de silicium cristallin dopé de type n. Le substrat 1 comporte des motifs en pyramide inversée sur les première et seconde surfaces 10, 11. L'architecture est de type n à émetteur standard. La première zone semi-conductrice 100 forme l'émetteur. La deuxième surface semi-conductrice 110 est de type BSF. La première surface 10 est notée face avant, et la seconde surface 11 est notée face arrière.

Un empilement, comportant la deuxième couche diélectrique 3 et la deuxième couche diélectrique additionnelle 30, est déposé en face arrière par PECVD. La deuxième couche diélectrique 3 est un oxynitrure de silicium comportant des atomes de phosphore, noté SiOₓN_{y} :P. La deuxième couche diélectrique additionnelle 30 est un nitrure de silicium, notée SiNₓ.

Puis la première couche diélectrique 2 est déposée en face avant par PECVD. La première couche diélectrique 2 est un oxynitrure de silicium comportant des atomes de bore, notée SiOₓN_{y} :B.

Le recuit thermique appliqué lors de l'étape d) présente une valeur de température de recuit de 940°C, et une valeur de durée de recuit de 35 minutes.

Puis la première couche additionnelle 20 est déposée par PECVD en face avant après l'étape d). La première couche diélectrique additionnelle 20 est un nitrure de silicium, notée SiNₓ.

Puis les première et deuxième zones semi-conductrices 100, 110 sont mises en contact avec une électrode E par sérigraphie.

Le rendement de la cellule photovoltaïque obtenue est de 19,2% en moyenne, 19,4% en pointe.

Des mesures XPS ont été effectuées pour déterminer la proportion atomique dans les couches diélectriques avant et après le recuit thermique appliqué lors de l'étape d). Ces mesures sont rassemblées dans le tableau ci-après.

| | Avant l'étape d) | | Après l'étape d) | |
|---|---|---|---|---|
| Couches diélectriques (2, 20) | SiOₓN_{y} :B | SiNx | SiOₓN_{y} :B | SiNx |
| Proportion Si (%) | 20 | 45 | 25-30 | 40-45 |
| Proportion N (%) | <5 | 50-55 | 0 | 50-55 |
| Proportion O (%) | 20-55 | <5 | 60-65 | 0 |
| Proportion B (%) | 20 | <5 | 3-8 | <5 |

| Couches diélectriques (3, 30) | SiOxNy:P | SiNx | SiOxNy:P | SiNx |
|---|---|---|---|---|
| Proportion Si (%) | 45-55 | 45 | 45-55 | 45 |
| Proportion N (%) | <50 | 50-55 | <50 | 50-55 |
| Proportion O (%) | <5 | 0 | <5 | 0 |
| Proportion P (%) | <5 | 0 | <5 | 0 |

## Revendications

1. Procédé de fabrication d'une cellule photovoltaïque, comportant les étapes :
a) prévoir une structure (1, 2, 3) comportant :
- un substrat (1) en un matériau semi-conducteur à base de silicium cristallin, et comportant une première surface (10) et une seconde surface (11) opposée ;
- une première couche diélectrique (2) formée à la première surface (10) du substrat (1), et comportant des atomes de bore, la première couche diélectrique (2) étant à base d'un oxynitrure de silicium SiOₓN_{y} vérifiant 0 < y < x et *x* < 0,50, de préférence hydrogéné ;
- une deuxième couche diélectrique (3) formée à la seconde surface (11) du substrat (1), et comportant des atomes de phosphore ou d'arsenic ;
d) appliquer un recuit thermique à la structure (1, 2, 3) sous une atmosphère oxydante, ledit recuit thermique étant adapté pour :
- former une première zone semi-conductrice (100) destinée à être en contact avec une électrode (E), la première zone semi-conductrice (100) étant formée par une diffusion des atomes de bore dans le substrat (1) depuis la première couche diélectrique (2) jusqu'à la première surface (10) du substrat (1), la première zone semi-conductrice (100) et la première couche diélectrique (2) présentant une interface ;
- former une deuxième zone semi-conductrice (110) destinée à être en contact avec une électrode (E), la deuxième zone semi-conductrice (110) étant formée par une diffusion des atomes de phosphore ou d'arsenic dans le substrat (1) depuis la deuxième couche diélectrique (3) jusqu'à la seconde surface (11) du substrat (1) ;
- enrichir la première couche diélectrique (2) en oxygène de sorte que l'oxynitrure de silicium SiOₓN_{y} vérifie 0,50 ≤ *x* ≤ 0,66, après l'étape d), de manière à passiver l'interface ;
l'étape d) se déroulant de manière continue de sorte que la formation des première et deuxième zones semi-conductrices (100, 110) sont concomitantes ;
- f) former une électrode en contact avec la première zone semi-conductrice (100) à travers la première couche diélectrique (2) et une électrode en contact avec la deuxième zone semi-conductrice (110) à travers la deuxième couche diélectrique (3).

2. Procédé selon la revendication 1, **caractérisé en ce que** les atomes de bore présentent une proportion atomique dans la première couche diélectrique (2) comprise entre 10% et 50%, de préférence comprise entre 10% et 30%, avant l'étape d).

3. Procédé selon la revendication 1 ou 2, **caractérisé en ce que** les atomes de bore présentent une proportion atomique dans la première couche diélectrique (2) comprise entre 1% et 10%, de préférence comprise entre 3% et 8%, après l'étape d).

4. Procédé selon l'une des revendications 1 à 3, **caractérisé en ce que** l'oxynitrure de silicium SiOₓN_{y} vérifie 0<y≤0,10 de préférence 0<y≤0,05, avant l'étape d), et de préférence après l'étape d).

5. Procédé selon l'une des revendications 1 à 4, **caractérisé en ce que** le recuit thermique appliqué lors de l'étape d) présente :
- une valeur de température de recuit comprise entre 850°C et 950°C, de préférence comprise entre 900°C et 950°C,
- une valeur de durée de recuit comprise entre 10 minutes et 1 heure, de préférence comprise entre 30 minutes et 1 heure.

6. Procédé selon l'une des revendications 1 à 5, **caractérisé en ce que** les atomes de phosphore ou d'arsenic présentent une proportion atomique dans la deuxième couche diélectrique (3) comprise entre 1% et 10% avant l'étape d).

7. Procédé selon l'une des revendications 1 à 6, **caractérisé en ce que** les atomes de phosphore ou d'arsenic présentent une proportion atomique dans la deuxième couche diélectrique (3) comprise entre 1% et 10%, de préférence comprise entre 1% et 5%, après l'étape d).

8. Procédé selon l'une des revendications 1 à 7, **caractérisé en ce que** la deuxième couche diélectrique (3) est à base d'un oxynitrure de silicium SiOₓN_{y} vérifiant 0 ≤ *x* < *y*, de préférence hydrogéné.

9. Procédé selon la revendication 8, **caractérisé en ce que** l'oxynitrure de silicium SiOₓN_{y} de la deuxième couche diélectrique (3) vérifie 0 ≤ *x* ≤ 0,05 avant et après l'étape d).

10. Procédé selon la revendication 8 ou 9, **caractérisé en ce que** l'oxynitrure de silicium SiOₓN_{y} de la deuxième couche diélectrique (3) vérifie 0,30 ≤ *y* ≤ 0,55 avant et après l'étape d).

11. Procédé selon l'une des revendications 1 à 10, **caractérisé en ce qu'**il comporte les étapes :
e1) former une première couche diélectrique additionnelle (20) sur la première couche diélectrique (2), l'étape e1) étant exécutée après l'étape d),
e2) former une deuxième couche diélectrique additionnelle (30) sur la deuxième couche diélectrique (3),
les première et deuxième couches diélectriques additionnelles (20, 30) étant chacune à base d'un oxynitrure de silicium SiOₓN_{y} vérifiant 0 ≤ *x* < *y,* de préférence hydrogéné.

12. Procédé selon l'une des revendications 1 à 11, comportant une étape consistant à former une couche à base de SiON, dépourvue d'atomes de bore, sur la première couche (2), ladite étape étant exécutée avant l'étape d).

13. Cellule photovoltaïque comportant :
- un substrat (1) en un matériau semi-conducteur à base de silicium cristallin, et comportant une première surface (10) et une seconde surface (11) opposée ;
- des première et deuxième zones semi-conductrices (100, 110) s'étendant respectivement sous la première surface (10) et sous la seconde surface (11) du substrat (1), la première zone semi-conductrice (100) comportant des atomes de bore, la deuxième zone semi-conductrice (110) comportant des atomes de phosphore ou d'arsenic ;
- une première couche (2) d'un matériau diélectrique formée à la première surface (10) du substrat (1), le matériau diélectrique étant à base d'un oxynitrure de silicium SiOₓN_{y} vérifiant 0<y<x avec 0,50 ≤ *x* ≤ 0,66, le matériau diélectrique de la première couche (2) comportant des atomes de bore présentant une proportion atomique comprise entre 1% et 10% et de préférence de l'hydrogène ;
- une deuxième couche (3) d'un matériau diélectrique formée à la seconde surface (11) du substrat (1), le matériau diélectrique de la deuxième couche (3) comportant des atomes de phosphore ou d'arsenic présentant une proportion atomique comprise entre 1% et 10 % ;
- une électrode (E) en contact avec la première zone semi-conductrice (100) à travers la première couche diélectrique (2) et une électrode (E) en contact avec la deuxième zone semi-conductrice (110) à travers la deuxième couche diélectrique (3).

14. Cellule photovoltaïque selon la revendication 13, **caractérisée en ce que** l'oxynitrure de silicium SiOₓN_{y} vérifie 0<y≤0,10, de préférence 0<y≤0,05.

15. Cellule photovoltaïque selon la revendication 13 ou 14, **caractérisée en ce que** les atomes de bore présentent une proportion atomique dans le matériau diélectrique de la première couche (2) comprise entre 3% et 8%.

16. Cellule photovoltaïque selon l'une des revendications 13 à 15, **caractérisée en ce que** le matériau diélectrique de la deuxième couche (3) est à base d'un oxynitrure de silicium SiOₓN_{y} vérifiant 0 ≤ *x* < *y*, et comporte de préférence de l'hydrogène.

17. Cellule photovoltaïque selon la revendication 16, **caractérisée en ce que** l'oxynitrure de silicium SiOₓN_{y} de la deuxième couche (3) vérifie 0 ≤ *x* ≤ 0,05.

18. Cellule photovoltaïque selon la revendication 16 ou 17, **caractérisée en ce que** l'oxynitrure de silicium SiOₓN_{y} de la deuxième couche (3) vérifie 0,30 ≤ *y* ≤ 0,55.

19. Cellule photovoltaïque selon l'une des revendications 13 à 18, **caractérisée en ce que** les atomes de phosphore ou d'arsenic présentent une proportion atomique dans le matériau diélectrique de la deuxième couche (3) comprise entre 1% et 5%.

20. Cellule photovoltaïque selon l'une des revendications 13 à 19, **caractérisée en ce qu'**elle comporte des première et deuxième couches diélectriques additionnelles (20, 30) formées respectivement sur les première et deuxième couches diélectriques (2, 3), et **en ce que** les première et deuxième couches diélectriques additionnelles (20, 30) sont, de préférence, chacune à base d'un oxynitrure de silicium SiOₓN_{y} vérifiant 0 ≤ *x* < *y*, de préférence hydrogéné.

21. Cellule photovoltaïque selon l'une des revendications 13 à 20, **caractérisée en ce que** la première couche (2) présente une épaisseur comprise entre 3 nm et 100 nm, de préférence comprise entre 20 nm et 35 nm.

22. Cellule photovoltaïque selon l'une des revendications 13 à 21, comportant une couche à base de B₂O₃ formée entre la première surface (10) du substrat (1) et la première couche (2).

## Patentansprüche

1. Verfahren zur Herstellung einer Photovoltaikzelle, umfassend die Schritte:
a) Bereitstellen einer Struktur (1, 2, 3), umfassend:
- ein Substrat (1) aus einem Halbleitermaterial auf der Basis von kristallinem Silicium, das eine erste Oberfläche (10) und eine entgegengesetzte zweite Oberfläche (11) umfasst;
- eine erste dielektrische Schicht (2), die an der ersten Oberfläche (10) des Substrats (1) gebildet ist und Boratome umfasst, wobei die erste dielektrische Schicht (2) auf der Basis eines, bevorzugt hydrierten, Siliciumoxinitrids SiOₓN_{y} ist, das die Bedingung 0 < y < x und *x* < 0,50 erfüllt;
- eine zweite dielektrische Schicht (3), die an der zweiten Oberfläche (11) des Substrats (1) gebildet ist und Phosphor- oder Arsenatome umfasst;
d) Anwenden eines thermischen Glühens auf die Struktur (1, 2, 3) unter einer oxidierenden Atmosphäre, wobei das thermische Glühen geeignet ist, um:
- einen ersten Halbleiterbereich (100) zu bilden, der dazu bestimmt ist, mit einer Elektrode (E) in Kontakt zu sein, wobei der erste Halbleiterbereich (100) durch eine Diffusion der Boratome in das Substrat (1) von der ersten dielektrischen Schicht (2) aus bis zu der ersten Oberfläche (10) des Substrats (1) gebildet wird, wobei der erste Halbleiterbereich (100) und die erste dielektrische Schicht (2) eine Grenzfläche aufweisen;
- einen zweiten Halbleiterbereich (110) zu bilden, der dazu bestimmt ist, mit einer Elektrode (E) in Kontakt zu sein, wobei der zweite Halbleiterbereich (110) durch eine Diffusion der Phosphor- oder Arsenatome in das Substrat (1) von der zweiten dielektrischen Schicht (3) aus bis zu der zweiten Oberfläche (11) des Substrats (1) gebildet wird;
- die erste dielektrische Schicht (2) mit Sauerstoff anzureichern, so dass das Siliciumoxinitrid SiOₓN_{y} nach dem Schritt d) die Bedingung 0,50 ≤ *x* ≤ 0,66 erfüllt, so dass die Grenzfläche passiviert wird;
wobei der Schritt d) kontinuierlich abläuft, so dass das Bilden der ersten und zweiten Halbleiterbereiche (100, 110) gleichzeitig erfolgt;
- f) Bilden einer Elektrode in Kontakt mit dem ersten Halbleiterbereich (100) durch die erste dielektrische Schicht (2) hindurch und einer Elektrode in Kontakt mit dem zweiten Halbleiterbereich (110) durch die zweite dielektrische Schicht (3) hindurch.

2. Verfahren nach Anspruch 1, **dadurch gekennzeichnet, dass** die Boratome vor dem Schritt d) ein Atomverhältnis in der ersten dielektrischen Schicht (2) zwischen 10 % und 50 %, bevorzugt zwischen 10 % und 30 % aufweisen.

3. Verfahren nach Anspruch 1 oder 2, **dadurch gekennzeichnet, dass** die Boratome nach dem Schritt d) ein Atomverhältnis in der ersten dielektrischen Schicht (2) zwischen 1 % und 10 %, bevorzugt zwischen 3 % und 8 % aufweisen.

4. Verfahren nach einem der Ansprüche 1 bis 3, **dadurch gekennzeichnet, dass** das Siliciumoxinitrid SiOₓN_{y} vor dem Schritt d) und bevorzugt nach dem Schritt d) die Bedingung 0<y≤0,10, bevorzugt 0<y≤0,05 erfüllt.

5. Verfahren nach einem der Ansprüche 1 bis 4, **dadurch gekennzeichnet, dass** das beim Schritt d) angewandte thermische Glühen aufweist:
- einen Glühtemperaturwert zwischen 850 °C und 950 °C, bevorzugt zwischen 900 °C und 950 °C,
- einen Glühzeitwert zwischen 10 Minuten und 1 Stunde, bevorzugt zwischen 30 Minuten und 1 Stunde.

6. Verfahren nach einem der Ansprüche 1 bis 5, **dadurch gekennzeichnet, dass** die Phosphor- oder Arsenatome vor dem Schritt d) ein Atomverhältnis in der zweiten dielektrischen Schicht (3) zwischen 1 % und 10 % aufweisen.

7. Verfahren nach einem der Ansprüche 1 bis 6, **dadurch gekennzeichnet, dass** die Phosphor- oder Arsenatome nach dem Schritt d) ein Atomverhältnis in der zweiten dielektrischen Schicht (3) zwischen 1 % und 10 %, bevorzugt zwischen 1 % und 5 % aufweisen.

8. Verfahren nach einem der Ansprüche 1 bis 7, **dadurch gekennzeichnet, dass** die zweite dielektrische Schicht (3) auf der Basis eines, bevorzugt hydrierten, Siliciumoxinitrids SiOₓN_{y} ist, das die Bedingung 0 ≤ *x* < *y* erfüllt.

9. Verfahren nach Anspruch 8, **dadurch gekennzeichnet, dass** das Siliciumoxinitrid SiOₓN_{y} der zweiten dielektrischen Schicht (3) vor und nach dem Schritt d) die Bedingung 0 ≤ *x* ≤ 0,05 erfüllt.

10. Verfahren nach Anspruch 8 oder 9, **dadurch gekennzeichnet, dass** das Siliciumoxinitrid SiOₓN_{y} der zweiten dielektrischen Schicht (3) vor und nach dem Schritt d) die Bedingung 0,30 ≤ *y* ≤ 0,55 erfüllt.

11. Verfahren nach einem der Ansprüche 1 bis 10, **dadurch gekennzeichnet, dass** es die Schritte umfasst:
e1) Bilden einer zusätzlichen ersten dielektrischen Schicht (20) auf der ersten dielektrischen Schicht (2), wobei der Schritt e1) nach dem Schritt d) ausgeführt wird,
e2) Bilden einer zusätzlichen zweiten dielektrischen Schicht (30) auf der zweiten dielektrischen Schicht (3),
wobei die zusätzlichen ersten und zweiten dielektrischen Schichten (20, 30) jeweils auf der Basis eines, bevorzugt hydrierten, Siliciumoxinitrids SiOₓN_{y} sind, das die Bedingung 0 ≤ *x* < *y* erfüllt.

12. Verfahren nach einem der Ansprüche 1 bis 11, umfassend einen Schritt, der darin besteht, eine Schicht auf der Basis von SiON, die frei von Boratomen ist, auf der ersten Schicht (2) zu bilden, wobei der Schritt vor dem Schritt d) ausgeführt wird.

13. Photovoltaikzelle, umfassend:
- ein Substrat (1) aus einem Halbleitermaterial auf der Basis von kristallinem Silicium, das eine erste Oberfläche (10) und eine entgegengesetzte zweite Oberfläche (11) umfasst;
- erste und zweite Halbleiterbereiche (100, 110), die sich unter der ersten Oberfläche (10) beziehungsweise unter der zweiten Oberfläche (11) des Substrats (1) erstrecken, wobei der erste Halbleiterbereich (100) Boratome umfasst, wobei der zweite Halbleiterbereich (110) Phosphor- oder Arsenatome umfasst;
- eine erste Schicht (2) aus einem dielektrischen Material, die an der ersten Oberfläche (10) des Substrats (1) gebildet ist, wobei das dielektrische Material auf der Basis eines Siliciumoxinitrids SiOₓN_{y} ist, das die Bedingung 0<y<x mit 0,50 ≤ *x* ≤ 0,66 erfüllt, wobei das dielektrische Material der ersten Schicht (2) Boratome, die ein Atomverhältnis zwischen 1% und 10% aufweisen, und bevorzugt Wasserstoff umfasst;
- eine zweite Schicht (3) aus einem dielektrischen Material, die an der zweiten Oberfläche (11) des Substrats (1) gebildet ist, wobei das dielektrische Material der zweiten Schicht (3) Phosphor- oder Arsenatome umfasst, die ein Atomverhältnis zwischen 1 % und 10 % aufweisen;
- eine Elektrode (E) in Kontakt mit dem ersten Halbleiterbereich (100) durch die erste dielektrische Schicht (2) hindurch und eine Elektrode (E) in Kontakt mit dem zweiten Halbleiterbereich (110) durch die zweite dielektrische Schicht (3) hindurch.

14. Photovoltaikzelle nach Anspruch 13, **dadurch gekennzeichnet, dass** das Siliciumoxinitrid SiOₓN_{y} die Bedingung 0<y≤0,10, bevorzugt 0<y≤0,05 erfüllt.

15. Photovoltaikzelle nach Anspruch 13 oder 14, **dadurch gekennzeichnet, dass** die Boratome ein Atomverhältnis in dem dielektrischen Material der ersten Schicht (2) zwischen 3 % und 8 % aufweisen.

16. Photovoltaikzelle nach einem der Ansprüche 13 bis 15, **dadurch gekennzeichnet, dass** das dielektrische Material der zweiten Schicht (3) auf der Basis eines Siliciumoxinitrids SiOₓN_{y} ist, das die Bedingung 0 ≤ *x* < *y* erfüllt, und bevorzugt Wasserstoff umfasst.

17. Photovoltaikzelle nach Anspruch 16, **dadurch gekennzeichnet, dass** das Siliciumoxinitrid SiOₓN_{y} der zweiten Schicht (3) die Bedingung 0 ≤ *x* ≤ 0,05 erfüllt.

18. Photovoltaikzelle nach Anspruch 16 oder 17, **dadurch gekennzeichnet, dass** das Siliciumoxinitrid SiOₓN_{y} der zweiten Schicht (3) die Bedingung 0,30 ≤ *y* ≤ 0,55 erfüllt.

19. Photovoltaikzelle nach einem der Ansprüche 13 bis 18, **dadurch gekennzeichnet, dass** die Phosphor- oder Arsenatome ein Atomverhältnis in dem dielektrischen Material der zweiten Schicht (3) zwischen 1 % und 5 % aufweisen.

20. Photovoltaikzelle nach einem der Ansprüche 13 bis 19, **dadurch gekennzeichnet, dass** sie zusätzliche erste und zweite dielektrische Schichten (20, 30) umfasst, die auf den ersten beziehungsweise zweiten dielektrischen Schichten (2, 3) gebildet sind, und dass die zusätzlichen ersten und zweiten dielektrischen Schichten (20, 30) bevorzugt jeweils auf der Basis eines, bevorzugt hydrierten, Siliciumoxinitrids SiOₓN_{y} sind, das die Bedingung 0 ≤ *x* < *y* erfüllt.

21. Photovoltaikzelle nach einem der Ansprüche 13 bis 20, **dadurch gekennzeichnet, dass** die erste Schicht (2) eine Dicke zwischen 3 nm und 100 nm, bevorzugt zwischen 20 nm und 35 nm aufweist.

22. Photovoltaikzelle nach einem der Ansprüche 13 bis 21, umfassend eine Schicht auf der Basis von B₂O₃, die zwischen der ersten Oberfläche (10) des Substrats (1) und der ersten Schicht (2) gebildet ist.

## Claims

1. Method for manufacturing a photovoltaic cell, comprising the steps of:
a) providing a structure (1, 2, 3) comprising:
- a substrate (1) made of a crystalline silicon-based semiconducting material and comprising a first surface (10) and a second, opposite surface (11);
- a first dielectric layer (2) formed on the first surface (10) of the substrate (1) and comprising boron atoms, the first dielectric layer (2) being based on a preferably hydrogenated silicon oxynitride SiOₓN_{y} respecting 0 < y < x and x < 0.50;
- a second dielectric layer (3) formed on the second surface (11) of the substrate (1) and comprising phosphorous or arsenic atoms;
d) applying a thermal anneal to the structure (1, 2, 3) under an oxidizing atmosphere, said thermal anneal being suitable for:
- forming a first semiconducting zone (100) intended to be in contact with an electrode (E), the first semiconducting zone (100) being formed by diffusion of the boron atoms into the substrate (1) from the first dielectric layer (2) to the first surface (10) of the substrate (1), the first semiconducting zone (100) and the first dielectric layer (2) having an interface;
- forming a second semiconducting zone (110) intended to be in contact with an electrode (E), the second semiconducting zone (110) being formed by diffusion of the phosphorous or arsenic atoms into the substrate (1) from the second dielectric layer (3) to the second surface (11) of the substrate (1);
- enriching the first dielectric layer (2) with oxygen so that the silicon oxynitride SiOₓN_{y} respects 0.50 ≤ x ≤ 0.66 after step d), so as to passivate the interface;
step d) taking place continuously so that the first and second semiconducting zones (100, 110) are formed concomitantly;
f) forming an electrode in contact with the first semiconducting zone (100) through the first dielectric layer (2) and an electrode in contact with the second semiconducting zone (110) through the second dielectric layer (3).

2. Method according to Claim 1, **characterized in that** the atomic proportion of the boron atoms in the first dielectric layer (2) is between 10% and 50%, preferably between 10% and 30%, before step d).

3. Method according to Claim 1 or 2, **characterized in that** the atomic proportion of the boron atoms in the first dielectric layer (2) is between 1% and 10%, preferably between 3% and 8%, after step d).

4. Method according to one of Claims 1 to 3, **characterized in that** the silicon oxynitride SiOₓN_{y} respects 0 < y ≤ 0.10, preferably 0 < y ≤ 0.05, before step d) and preferably after step d).

5. Method according to one of Claims 1 to 4, **characterized in that** the thermal anneal applied in step d) features:
- an annealing temperature value of between 850°C and 950°C, preferably of between 900°C and 950°C,
- an annealing time value of between 10 minutes and 1 hour, preferably of between 30 minutes and 1 hour.

6. Method according to one of Claims 1 to 5, **characterized in that** the atomic proportion of the phosphorous or arsenic atoms in the second dielectric layer (3) is between 1% and 10% before step d).

7. Method according to one of Claims 1 to 6, **characterized in that** the atomic proportion of the phosphorous or arsenic atoms in the second dielectric layer (3) is between 1% and 10%, preferably between 1% and 5%, after step d).

8. Method according to one of Claims 1 to 7, **characterized in that** the second dielectric layer (3) is based on a preferably hydrogenated silicon oxynitride SiOₓN_{y} respecting 0 ≤ x < y.

9. Method according to Claim 8, **characterized in that** the silicon oxynitride SiOₓN_{y} of the second dielectric layer (3) respects 0 ≤ x ≤ 0.05 before and after step d).

10. Method according to Claim 8 or 9, **characterized in that** the silicon oxynitride SiOₓN_{y} of the second dielectric layer (3) respects 0.30 ≤ y ≤ 0.55 before and after step d).

11. Method according to one of Claims 1 to 10, **characterized in that** it comprises the steps of:
e1) forming a first additional dielectric layer (20) on the first dielectric layer (2), step e1) being performed after step d),
e2) forming a second additional dielectric layer (30) on the second dielectric layer (3),
the first and second additional dielectric layers (20, 30) each being based on a preferably hydrogenated silicon oxynitride SiOₓN_{y} respecting 0 ≤ x < y.

12. Method according to one of Claims 1 to 11, comprising a step of forming an SiON-based layer devoid of boron atoms on the first layer (2), said step being performed before step d).

13. Photovoltaic cell comprising:
- a substrate (1) made of a crystalline silicon-based semiconducting material and comprising a first surface (10) and a second, opposite surface (11);
- first and second semiconducting zones (100, 110) extending respectively under the first surface (10) and under the second surface (11) of the substrate (1), the first semiconducting zone (100) comprising boron atoms, the second semiconducting zone (110) comprising phosphorous or arsenic atoms,
- a first layer (2) of a dielectric material, formed on the first surface (10) of the substrate (1), the dielectric material being based on a silicon oxynitride SiOₓN_{y} respecting 0 < y < x with 0.50 ≤ x ≤ 0.66, the dielectric material of the first layer (2) comprising boron atoms in an atomic proportion of between 1 % and 10% and preferably hydrogen atoms;
- a second layer (3) of a dielectric material, formed on the second surface (11) of the substrate (1), the dielectric material of the second layer (3) comprising phosphorous or arsenic atoms in an atomic proportion of between 1% and 10%;
- an electrode (E) in contact with the first semiconducting zone (100) through the first dielectric layer (2), and an electrode (E) in contact with the second semiconducting zone (110) through the second dielectric layer (3).

14. Photovoltaic cell according to Claim 13, **characterized in that** the silicon oxynitride SiOₓN_{y} respects 0 < y ≤ 0.10, preferably 0 < y ≤ 0.05.

15. Photovoltaic cell according to Claim 13 or 14, **characterized in that** the atomic proportion of the boron atoms in the dielectric material of the first layer (2) is between 3% and 8%.

16. Photovoltaic cell according to one of Claims 13 to 15, **characterized in that** the dielectric material of the second layer (3) is based on a silicon oxynitride SiOₓN_{y} respecting 0 ≤ x < y and preferably comprises hydrogen.

17. Photovoltaic cell according to Claim 16, **characterized in that** the silicon oxynitride SiOₓN_{y} of the second layer (3) respects 0 ≤ x ≤ 0.05.

18. Photovoltaic cell according to Claim 16 or 17, **characterized in that** the silicon oxynitride SiOₓN_{y} of the second layer (3) respects 0.30 ≤ y ≤ 0.55.

19. Photovoltaic cell according to one of Claims 13 to 18, **characterized in that** the atomic proportion of the phosphorous or arsenic atoms in the dielectric material of the second layer (3) is between 1% and 5%.

20. Photovoltaic cell according to one of Claims 13 to 19, **characterized in that** it comprises first and second additional dielectric layers (20, 30) formed respectively on the first and second dielectric layers (2, 3), and **in that** the first and second additional dielectric layers (20, 30) are preferably each based on a preferably hydrogenated silicon oxynitride SiOₓN_{y} respecting 0 ≤ x < y.

21. Photovoltaic cell according to one of Claims 13 to 20, **characterized in that** the first layer (2) has a thickness of between 3 nm and 100 nm, preferably of between 20 nm and 35 nm.

22. Photovoltaic cell according to one of Claims 13 to 21, comprising a B₂O₃-based layer formed between the first surface (10) of the substrate (1) and the first layer (2).
